(19) Europäisches Patentamt
European Patent Office
Office européen des brevets

(11) **EP 2 817 828 B1**

(12) **EUROPÄISCHE PATENTSCHRIFT**

(45) Veröffentlichungstag und Bekanntmachung des Hinweises auf die Patenterteilung:
**10.02.2016   Patentblatt 2016/06**

(21) Anmeldenummer: **13704096.0**

(22) Anmeldetag: **12.02.2013**

(51) Int Cl.:
*H01L 31/02* (2006.01)          *H02J 3/38* (2006.01)

(86) Internationale Anmeldenummer:
**PCT/EP2013/052732**

(87) Internationale Veröffentlichungsnummer:
**WO 2013/124182 (29.08.2013 Gazette 2013/35)**

(54) **SCHUTZ VON PHOTOVOLTAIKMODULEN EINES PHOTOVOLTAIKGENERATORS VOR ÜBERSPANNUNGEN GEGENÜBER ERDE**

PROTECTION FROM SURGES RELATIVE TO EARTH FOR PHOTOVOLTAIC MODULES OF A PHOTOVOLTAIC GENERATOR

PROTECTION DE MODULES PHOTOVOLTAÏQUES D'UN GÉNÉRATEUR PHOTOVOLTAÏQUE CONTRE DES SURTENSIONS PAR RAPPORT À LA TERRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.02.2012   DE 102012101340**

(43) Veröffentlichungstag der Anmeldung:
**31.12.2014   Patentblatt 2015/01**

(73) Patentinhaber: **SMA Solar Technology AG 34266 Niestetal (DE)**

(72) Erfinder: **FALK, Andreas 34131 Kassel (DE)**

(56) Entgegenhaltungen:
**EP-A1- 2 284 973          DE-A1-102010 017 746
DE-A1-102010 060 463     DE-A1-102011 015 392**

EP 2 817 828 B1

**Beschreibung**

## TECHNISCHES GEBIET DER ERFINDUNG

Die Erfindung bezieht sich auf ein Verfahren, um einen Photovoltaikgenerator, der eine Leerlaufspannung aufweist, welche größer als eine Isolationsbemessungsspannung seiner Photovoltaikmodule ist, und der über einen Wechselrichter an ein Wechselstromnetz angeschlossen ist, beim Auftreten eines Erdschlussfehlers vor einer resultierenden, die Isolationsbemessungsspannung überschreitenden Überspannung gegenüber Erde zu schützen, wobei das Verfahren die Merkmale des Oberbegriffs des unabhängigen Patentanspruchs 1 aufweist.

## STAND DER TECHNIK

Ein Photovoltaikgenerator weist typischerweise mindestens einen, in der Regel mehrere parallel geschaltete Strings aus in Reihe geschalteten Photovoltaikmodulen auf.

Wird ein gegenüber Erde isolierter Photovoltaikgenerator ohne Erdbezug betrieben, teilt sich die Systemspannung, d. h. die zwischen den Anschlüssen des Photovoltaikgenerators an den Wechselrichter anliegende Spannung symmetrisch gegenüber Erde auf. Die maximal an einem Photovoltaikmodul des Photovoltaikgenerators auftretende Spannung gegenüber Erde ist dann die halbe Systemspannung.

Je nach Aufbau des Wechselrichters, zum Beispiel bei galvanischer Trennung im Bereich des Wechselrichters oder bei Verwendung eines galvanisch trennenden Transformators, ist es möglich, einen Punkt des Photovoltaikgenerators direkt zu erden oder die Spannung dieses Punktes gegenüber Erde, d. h. sein Potential, mit geeigneten Mitteln indirekt vorzugeben. So kann z. B. der Mittelpunkt eines Photovoltaikgenerators geerdet werden, um die Systemspannung symmetrisch gegenüber Erde aufzuteilen. Oder es kann der positive oder negative Anschluss eines Photovoltaikgenerators an den Wechselrichter geerdet werden, um alle seine Photovoltaikmodule auf negativem bzw. positivem Potential zu halten, was für die Lebensdauer bestimmter Photovoltaikmodule vorteilhaft ist oder das Potential des Mittelpunkts oder des positiven oder negativen Anschlusses gegen Erde asymmetrisch vorzugeben, siehe DE 20 2006 008 936 U1. Bei einem Erdschlussfehler im Bereich des Photovoltaikgenerators oder seiner Anschlüsse an den Wechselrichter ist dieser Erdbezug zur Vermeidung großer Erdströme jedoch sofort aufzuheben.

Beim Auftreten eines Erdschlussfehlers an einem gegenüber Erde isoliert betriebenen oder in folge des Erdschlussfehlers gezielt von Erde getrennten Photovoltaikgenerators besteht die Gefahr, dass Teile des Photovoltaikgenerators gegenüber Erde auf die volle Systemspannung angehoben werden. Dies ist dann kritisch, wenn die Systemspannung die Isolations-bemessungsspannung der Photovoltaikmodule des Photovoltaikgenerators überschreitet. Die Isolationsbemessungsspannung ist der Betrag der Spannung, die zwischen einem Photovoltaikmodul des Photovoltaikgenerators und Erde maximal anliegen darf, weil die Photovoltaikmodule für darüber hinaus gehende Spannungen keinen ausreichenden Isolationsschutz aufweisen und/oder weil es nach einzuhaltenden Sicherheitsbestimmungen generell unzulässig ist, diese Isolationsbemessungsspannung an dem Photovoltaikgenerator zu überschreiten.

Da die Systemspannung beim Betrieb eines Photovoltaikgenerators dessen Leerlaufspannung nicht überschreitet, besteht die Gefahr von die Isolationsbemessungsspannung seiner Photovoltaikmodule überschreitenden Überspannungen nur dann, wenn der Photovoltaikgenerator eine größere Leerlaufspannung als die Isolationsbemessungsspannung seiner Photovoltaikmodule aufweist. Umgekehrt besteht sie aber tatsächlich bei jedem Photovoltaikgenerator, dessen Leerlaufspannung die Isolationsbemessungsspannung seiner Photovoltaikmodule überschreitet, weil sich der Photovoltaikgenerator beim Auftreten eines Erdschlussfehlers im Leerlauf befinden kann.

Vergleichsweise hohe Systemspannungen auf der Gleichspannungsseite eines Wechselrichters sind beim Einspeisen von elektrischer Energie von einem Photovoltaikgenerator in ein Wechselstromnetz von Vorteil, um die zur Übertragung einer bestimmten elektrischen Leistung von dem Photovoltaikgenerator zu dem Wechselrichter notwendigerweise fließenden Ströme und damit die zur Leitung dieser Ströme erforderlichen Leitungsquerschnitte zu begrenzen.

Aus der DE 10 2010 017 746 A1 ist ein Verfahren zur Begrenzung einer Spannung eines Generators einer photovoltaischen Anlage im Gefahrenfall unter Verwendung einer in einem Wechselrichter angeordneten Vorrichtung bekannt, das die Merkmale des Oberbegriffs des unabhängigen Patentanspruchs 1 aufweist. Beim Auftreten eines Erdschlussfehlers wird der Generator zwischen seinen Anschlüssen an den Wechselrichter über eine Kurzschlusseinrichtung kurzgeschlossen. Details zu der Kurzschlusseinrichtung sind nicht angegeben.

Eine für die Durchführung eines Verfahrens mit den Merkmalen des Oberbegriffs des unabhängigen Patentanspruchs 1 geeignete Sicherheitsvorrichtung, bei der ein Schütz zum Kurzschließen des Photovoltaikgenerators vorgesehen ist, ist aus der WO 2011/135239 A1 bekannt. Das Schütz muss groß dimensioniert sein, insbesondere dann, wenn der Photovoltaikgenerator eine Vielzahl von parallel geschalteten Strings aus in Reihe geschalteten Photovoltaikmodulen aufweist. In diesem Fall kann der Kurzschlussstrom sehr viel größer als der Nennstrom von dem Photovoltaikgenerator ausfallen. Dadurch wird das Schütz zum Kurzschließen des Photovoltaikgenerators sehr teuer.

Aus der DE 30 41 078 A1 ist es zur Begrenzung einer Photovoltaikspannung auf einen für angeschlossene Verbraucher zulässigen Wert bekannt, einen Teil des die Photovoltaikspannung bereitstellenden Photovoltaikgenerators, d. h. einen Teil seiner Photovoltaikmodule, mit einem Schalter periodisch zeitweise kurzzuschließen. Dabei ist die nicht von dem Schalter überbrückte Photovoltaikspannung immer kleiner oder gleich der höchstzulässigen bzw. der Nennspannung der angeschlossenen Geräte. Der Schalter zum Kurzschließen eines Teils des Photovoltaikgenerators ist am Ort des Photovoltaikgenerators angeordnet. Wenn der Photovoltaikgenerator mehrere parallel geschaltete Strings aus Photovoltaikmodulen aufweist, ist für jeden der Strings ein Schalter zum teilweisen Kurzschließen vorzusehen.

Aus der DE 10 2010 009 120 B4 ist es als Fortbildung der Lehre der DE 30 41 078 A1 bekannt, eine Photovoltaikgroßanlage vor Überspannungen bei fehlender Wechselstromeinspeisung zu schützen, indem nur bei einigen seiner parallel geschalteten Strings ein Kurzschlussschalter vorgesehen wird, mit dem ein Teil der Photovoltaikmodule des jeweiligen Strings kurzgeschlossen wird. Dadurch soll auch das Potential der Strings ohne Kurzschlussschalter auf das niedrigere Potential und damit auf einen ungefährlichen Wert heruntergezogen werden. Hier werden zwar weniger, aber immer noch einige Schalter außerhalb des Wechselrichters, über den in das Wechselstromnetz eingespeist wird, eingesetzt. Außerdem reicht es wohl kaum aus, nur Teile von wenigen Strings eines Photovoltaikgenerators kurzzuschließen, weil sonst die Gefahr besteht, dass die Systemspannung hierdurch nicht absinkt, sondern vielmehr ein Rückstrom durch die teilweise kurzgeschlossenen Strings hervorgerufen wird, wenn dies nicht mit Hilfe zusätzlicher, den apparativen Aufwand dieser Lösung weiter steigernder Maßnahmen verhindert wird.

**AUFGABE DER ERFINDUNG**

Der Erfindung liegt die Aufgabe zugrunde, ein Verfahren zum Schutz von Photovoltaikmodulen eines Photovoltaikgenerators vor Überspannungen gegenüber Erde beim Auftreten eines Erdschlussfehlers mit den Merkmalen des Oberbegriffs des unabhängigen Patentanspruchs 1 aufzuzeigen, das ohne großen apparativen Aufwand und kostspielige Bauteile in einem Wechselrichter zum Einspeisen von elektrischer Energie von dem Photovoltaikgenerator in ein Wechselstromnetz implementiert werden kann.

**LÖSUNG**

Erfindungsgemäß wird die Aufgabe durch ein Verfahren mit den Merkmalen des Patentanspruchs 1 gelöst. Bevorzugte Ausführungsformen des neuen Verfahrens sind in den abhängigen Patentansprüchen definiert.

**BESCHREIBUNG DER ERFINDUNG**

Das erfindungsgemäße Verfahren weist die Schritte auf:

- Überwachen des Photovoltaikgenerators auf das Auftreten eines Erdschlussfehlers oder einer aus einem Erdschlussfehler resultierenden, eine Isolationsbemessungsspannung überschreitenden Überspannung gegenüber Erde und
- beim Auftreten des Erdschlussfehlers oder der resultierenden Überspannung

  - zunächst Trennen des Photovoltaikgenerators von einer eingangsseitigen Zwischenkreiskapazität des Wechselrichters und des Wechselrichters von dem Wechselstromnetz,
  - dann Entladen der eingangsseitigen Zwischenkreiskapazität des Wechselrichters über einen Widerstand,
  - vor dem permanenten Schließen von Halbleiterschaltern einer Wechselrichterbrücke des Wechselrichters und dem Wiederverbinden des Photovoltaikgenerators mit der eingangsseitigen Zwischenkreiskapazität des Wechselrichters, um den Photovoltaikgenerator kurzzuschließen.

Dass ein Photovoltaikgenerator über die Halbleiterschalter einer Wechselrichterbrücke eines Wechselrichters, an den der Photovoltaikgenerator zum Einspeisen von elektrischer Energie in ein Wechselstromnetz angeschlossen ist, kurzgeschlossen werden kann, nachdem eine eingangsseitige Zwischenkreiskapazität des Wechselrichters zuvor über einen Widerstand entladen wurde, ist grundsätzlich aus der EP 2 284 973 A1 bekannt. Hier erfolgt das Kurzschließen des Photovoltaikgenerators, um die treibende Kraft für einen Rückstrom zu beseitigen, der bei einem von parallel geschalteten Strings des Photovoltaikgenerators registriert wurde. Dieses Registrieren erfolgt über Stromsensoren, die hier jedem einzelnen String zugeordnet sind und deren Signal dem Wechselrichter von außen zugeführt wird. Eine Überwachung des Photovoltaikgenerators auf Erdschlussfehler erfolgt hier nicht. Derartige Erdschlussfehler werden auch nicht indirekt in Form von Rückströmen registriert, da zumindest einfache Erdschlussfehler keine derartigen Rückströme verursachen. Auch ansonsten beschäftigt sich die EP 2 284 973 A1 nicht damit, eine Isolationsbemessungsspannung von Photovoltaikmodulen des Photovoltaikgenerators einzuhalten.

Zur Durchführung des erfindungsgemäßen Verfahrens reicht es aus, der eingangsseitigen Zwischenkreiskapazität des Wechselrichters eine Reihenschaltung aus dem Widerstand und einem Schalter parallel zu schalten, um durch Schließen des Schalters die Zwischenkreiskapazität über den Widerstand zu entladen, soweit ein solcher zuschaltbarer Entladungswiderstand nicht sowieso vorgesehen ist. Schütze zum Trennen des Photovoltaikgenerators von der eingangsseitigen Zwischenkreiskapazität und des Wechselrichters von dem Wechselstromnetz sind in aller Regel sowieso vorhanden.

Der Schalter, der der eingangsseitigen Zwischenkreiskapazität des Wechselrichters in Reihe mit dem Widerstand parallel geschaltet wird, muss keine besonderen Anforderungen erfüllen, da der Widerstand den durch den Schalter fließenden Strom auch bei maximal aufgeladener Zwischenkreiskapazität auf ein leicht beherrschbares Maß begrenzt. Der Schalter kann daher ein Halbleiterschalter sein. Er kann aber auch als Relais oder Schütz ausgebildet werden.

Indem die Halbleiterschalter der Wechselrichterbrücke des Wechselrichters beim Kurzschließen des Photovoltaikgenerators durch die zuvor entladene Zwischenkreiskapazität vor hohen Kurzschlussströmen geschützt werden, sind sie in der Lage, den zum Absenken der Systemspannung gewünschten Kurzschluss des Photovoltaikgenerators herbeizuführen, das heißt die dabei fließenden Kurzschlussströme zu tragen. Eine ausreichende Spannungsfestigkeit müssen sie zum Schalten der Leerlaufspannung des Photovoltaikgenerators sowieso aufweisen.

Bei dem erfindungsgemäßen Verfahren wird in Kauf genommen, dass in dem Zeitraum zwischen dem Trennen des Photovoltaikgenerators von der eingangsseitigen Zwischenkreiskapazität des Wechselrichters bis zu dem Wiederverbinden des Photovoltaikgenerators mit dem Wechselrichter die maximale Spannung an dem Photovoltaikgenerator gegenüber Erde nicht nur nicht reduziert wird, sondern sogar bis auf seine Leerlaufspannung ansteigen kann. Derart kurzzeitige Überspannungen mit einer Dauer von etwa einer oder auch mehreren Sekunden sind aber für die Integrität der Photovoltaikmodule des Photovoltaikgenerators unkritisch. Dabei ist zu berücksichtigen, dass die Überspannungen gegenüber Erde aufgrund eines Erdschlussfehlers bei dem erfindungsgemäßen Verfahren grundsätzlich auf etwa 50 % der Isolationsbemessungsspannung beschränkt sind. Derart beschränkte Überspannungen sind auch dann noch unkritisch, wenn sie beispielsweise 1 Minute anhalten.

Vorzugsweise werden zum Kurzschließen des Photovoltaikgenerators nicht nur einige, sondern alle Halbleiterschalter der Wechselrichterbrücke des Wechselrichters permanent geschlossen, sodass sich die resultierenden Ströme auf die parallel geschalteten Halbbrücken und deren Schalter verteilen.

Vorzugsweise werden alle Halbleiterschalter der Wechselrichterbrücke des Wechselrichters vorübergehend geöffnet, und zwar, sobald oder bevor der Wechselrichter von dem Wechselstromnetz getrennt wird, und solange, bis sie nach dem Entladen der eingangsseitigen Zwischenkreiskapazität des Wechselrichters permanent geschlossen werden. Grundsätzlich können die Halbleiterschalter der Wechselrichterbrücke des Wechselrichters aber noch so lange getaktet werden, bis sie dauerhaft geschlossen werden.

Vorzugsweise wird bei dem erfindungsgemäßen Verfahren der Photovoltaikgenerator zur gleichen Zeit von der eingangsseitigen Zwischenkreiskapazität des Wechselrichters getrennt, wie der Wechselrichter von dem Wechselstromnetz getrennt wird. Grundsätzlich kann aber auch die eine Trennung vor der anderen erfolgen. Denkbar ist zum Beispiel, dass der Photovoltaikgenerator sofort von dem Wechselrichter getrennt wird, während der Wechselrichter solange mit dem Wechselstromnetz verbunden bleibt und die Halbleiterschalter seiner Wechselrichterbrücke solange weiter getaktet werden, wie die Zwischenkreisspannung über seiner eingangsseitigen Zwischenkreiskapazität noch ein Einspeisen von elektrischer Energie in das Wechselstromnetz ermöglicht.

Weiterhin ist es bei dem erfindungsgemäßen Verfahren vom Timing her bevorzugt, wenn die Halbleiterschalter der Wechselrichterbrücke des Wechselrichters permanent geschlossen werden, bevor der Photovoltaikgenerator wieder mit der eingangsseitigen Zwischenkreiskapazität des Wechselrichters verbunden wird. Durch die Pufferwirkung der Zwischenkreiskapazität ist hier auch eine Gleichzeitigkeit oder eine schnelle umgekehrte Reihenfolge möglich.

Zwar bleibt die aufgrund des Kurzschlussstroms in den geschlossenen Halbleiterschaltern der Wechselrichterbrücke des Wechselrichters anfallende Verlustwärme klein. Dennoch ist es vorteilhaft, ihre Kühlung auch dann sicherzustellen, wenn eine Energieversorgung über das Wechselstromnetz nicht gewährleistet ist. Hierzu kann dem Wechselrichter ein spezieller Energiespeicher zugeordnet werden. Bei nicht normalerweise geschlossenen Halbleiterschaltern der Wechselrichterbrücke ist überdies auch für den Ausfall des Wechselstromnetzes sicherzustellen, dass die Halbleiterschalter permanent in ihren geschlossenen Zustand angesteuert werden können, um den Photovoltaikgenerator zur Vermeidung von Überspannungen dauerhaft kurzzuschließen.

Eine an dem Wechselrichter potentiell vorhandene Offsetsteuerung für das Potential eines der Anschlüsse des Photovoltaikgenerators am Eingang des Wechselrichters wird bei dem erfindungsgemäßen Verfahren im Falle des Auftretens eines Erdschlussfehlers oder einer resultierenden Überspannung abgeschaltet, soweit diese Offsetsteuerung nicht sowieso durch die im Rahmen des erfindungsgemäßen Verfahrens geänderte Ansteuerung des Wechselrichters ein Ende findet.

Beim Auftreten eines Erdschlussfehlers, der in keiner die Isolationsbemessungsspannung überschreitenden Überspannung resultiert, muss der Photovoltaikgenerator nicht kurzgeschlossen werden. Stattdessen kann weiter elektrische Energie von dem Photovoltaikgenerator mit dem Wechselrichter in das Wechselstromnetz eingespeist werden. Hartes Kriterium für das Kurzschließen des Photovoltaikgenerators gemäß dem erfindungsgemäßen Verfahren ist dann erst das Auftreten einer die Isolationsbemessungsspannung überschreitenden Überspannung, die binnen einer vorgegebenen Maximalzeit nicht von selbst zurückgeht.

Das erfindungsgemäße Verfahren kann in Bezug auf alle Maßnahmen, die zum Kurzschließen des Photovoltaikgenerators ergriffen werden, innerhalb des Wechselrichters oder zumindest am Ort des Wechselrichters durchgeführt werden. Dasselbe gilt für die Überwachung des Photovoltaikgenerators auf das Auftreten eines Erdschlussfehlers oder insbesondere auf das Auftreten einer resultierenden, die Isolationsbemessungsspannung überschreitenden Überspannung. Konkret kann der Photovoltaikgenerator durch Messen der Spannungen seiner Anschlüsse an den Wechselrichter gegenüber Erde überwacht werden.

Vorteilhafte Weiterbildungen der Erfindung ergeben sich aus den Patentansprüchen, der Beschreibung und den Zeichnungen. Die in der Beschreibungseinleitung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen. Die in den Patentansprüchen aufgeführten Merkmale können durch andere Merkmale ergänzt werden oder die einzigen Schritte definieren, aus denen das Verfahren besteht.

## KURZBESCHREIBUNG DER FIGUREN

Die Erfindung wird im Folgenden unter Bezugnahme auf die beigefügten Zeichnungen näher erläutert und beschrieben.

Fig. 1 zeigt einen über einen Wechselrichter an ein Wechselstromnetz angeschlossenen Photovoltaikgenerator im Normalbetrieb; und

Fig. 2 zeigt die zeitliche Abfolge der Schritte des erfindungsgemäßen Verfahrens und die resultierenden Spannungen an dem Wechselrichter gemäß Fig. 1 gegenüber Erde.

## FIGURENBESCHREIBUNG

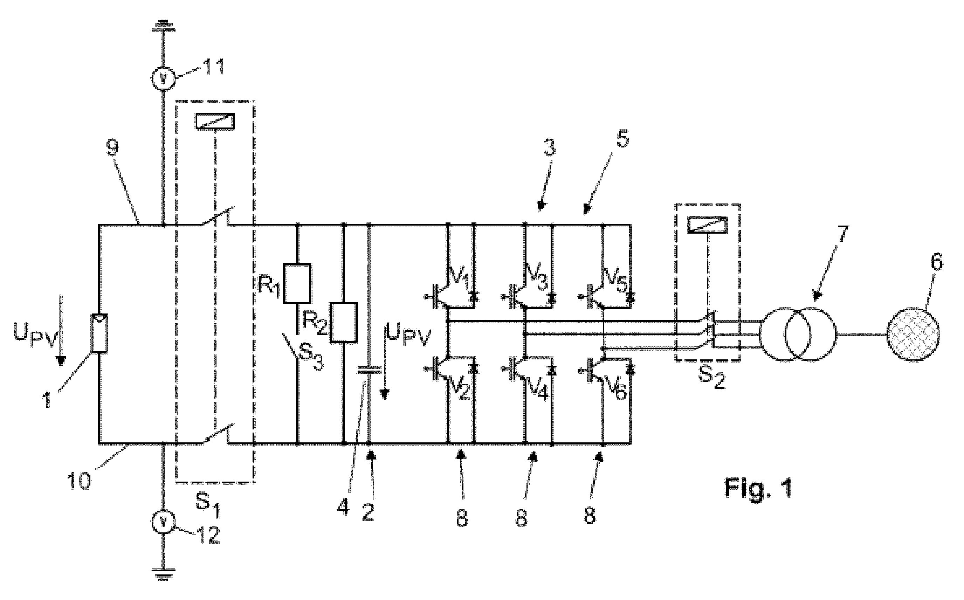

Gemäß **Fig. 1** ist ein Photovoltaikgenerator 1, der regelmäßig nicht nur eine Reihenschaltung von einzelnen Photovoltaikmodulen zu einem so genannten String, sondern auch eine Parallelschaltung derartiger Strings von Photovoltaikmodulen aufweist, über ein erstes Schütz S1 an einen eingangsseitigen Zwischenkreis 2 eines Wechselrichters 3 angeschlossen. Der Zwischenkreis 2 weist eine Zwischenkreiskapazität 4 auf. Aus dem von dem Photovoltaikgenerator 1 aufgeladenen Zwischenkreis 2 speist eine Wechselrichterbrücke 5 des Wechselrichters 3 elektrische Energie in ein Wechselstromnetz 6 ein. Dabei ist der Wechselrichter 3 über ein Schütz S2 und einen galvanisch trennenden Transformator 7 an das Wechselstromnetz 6 angeschlossen. Die Wechselrichterbrücke 5 weist hier zur Einspeisung eines dreiphasigen Wechselstroms in das Wechselstromnetz 6 drei Halbbrücken 8 auf, in denen jeweils zwei Halbleiterschalter V1 und V2, V3 und V4 bzw. V5 und V6 in Reihe geschaltet sind. Zwischen dem Schütz S1 und der Wechselrichterbrücke 5 ist der Zwischenkreiskapazität 4 eine Reihenschaltung aus einem Widerstand R1 und einem Schalter S3 parallel geschaltet, um die Zwischenkreiskapazität 4 durch Schließen des Schalters S3 über den Widerstand R1 schnell entladen zu können, insbesondere schneller als über einen der Zwischenkreiskapazität 4 zur Sicherheit permanent parallel geschalteten, hochohmigen Entladungswiderstand R2. Konkret ist der Widerstand R1 so dimensioniert, dass auch eine anfängliche Zwischenkreisspannung $U_{ZWK}$ über der Zwischenkreiskapazität 4, die die Höhe der Leerlaufspannung $U_0$ des Photovoltaikgenerators aufweist, binnen einer Zeit t auf eine Schwellspannung $U_{max}$ abfällt, wobei gilt:

$$U_{max} = U_0 \cdot e^{-t/R1 \cdot C},$$

wobei C der Wert der Zwischenkreiskapazität 4 ist. Bei einer Schwellspannung von z. B. 30 V, bei der die Zwischenkreisspannung 4 als Entladen angesehen werden kann, und einer typischen Zwischenkreiskapazität von 10 bis 20 mF, sowie einer tolerierbaren maximalen Entladezeit der Zwischenkreiskapazität 4 von beispielsweise einer Sekunde resultiert hieraus bei $U_0$ von beispielsweise 1.500 V ein Widerstand R1 von 12,5 bis 25 Ω. Dieser begrenzt den anfänglichen Kurzschlussstrom bei der Spannung von 1.500 V auf 60 bis 120 A, für die der Schalter S3 ausgelegt sein muss. Diese Auslegung ist mit einem preiswerten Halbleiterschalter, Relais oder Schütz möglich.
Genutzt wird der Schalter S3 zum Entladen der Zwischenkreiskapazität 4 dann, wenn bei Messungen von Spannungen an Anschlüssen 9 und 10 des Photovoltaikgenerators 1 an den Wechselrichter 3, die z. B. mit Voltmetern 11 und 12 durchgeführt werden können, festgestellt wird, dass eine Überspannung gegenüber Erde vorliegt, die eine Isolationsbemessungsspannung des Photovoltaikgenerators 1 bzw. seiner Photovoltaikmodule überschreitet. Im Normalbetrieb des Photovoltaikgenerators 1 verteilt sich dessen Ausgangsspannung $U_{PV}$ als Systemspannung des Wechselrichters 3 symmetrisch gegenüber Erde, sodass die beiden Voltmeter 11 und 12 betragsmäßig gleiche Spannungen U1 und U2 von jeweils der Hälfte von $U_{PV}$ messen. Die Zwischenkreisspannung $U_{ZWK}$ ist dabei gleich $U_{PV}$. Wenn es jedoch zu einem Erdschlussfehler kommt, der zum Beispiel den Anschluss 9 mit Erde verbindet, bricht die von dem Voltmeter 11 registrierte Spannung gegenüber Erde auf null zusammen, während die von dem Voltmeter 12 registrierte Spannung gegenüber Erde auf $U_{PV}$ ansteigt. Wenn $U_{PV}$ dabei die Isolationsbemessungsspannung überschreitet, was von den aktuellen Einstrahlungsbedingungen abhängig sein kann, muss dieser Zustand kurzfristig beseitigt werden. Dazu werden zunächst die Schütze S1 und S2 geöffnet, um den Wechselrichter 3 sowohl von dem Photovoltaikgenerator 1 als auch von dem Wechselstromnetz 6 zu trennen. Dann wird durch Schließen des Schalters S3 die Zwischenkreiskapazität 4 über den Widerstand R1 schnell entladen. Bei Erreichen der für die Halbleiterschalter V1 bis V6 akzeptablen Schwellspannung werden alle Halbleiterschalter V1 bis V6 der Wechselrichterbrücke 5, die beim Öffnen der Schütze S1 und S2 vorübergehend geöffnet wurden, permanent geschlossen, und durch erneutes Schließen des Schützes S1 wird dann der Photovoltaikgenerator 1 über die Wechselrichterbrücke 5 kurzgeschlossen. Dabei kann der Schalter S3 weiter geschlossen bleiben. Er allein ist aber nicht geeignet, um den Photovoltaikgenerator 1 zur Begrenzung der an ihm auftretenden Spannung gegenüber Erde kurzzuschließen, weil er gemeinsam mit dem Widerstand R1 für die zu diesem Zweck zu leitenden Ströme nicht ausgelegt ist. Diese Ströme werden aber problemlos von den Halbleiterschaltern V1 bis V6 der Wechselrichterbrücke 5 geleitet, wobei sie sich über deren drei Halbbrücken 8 verteilen.

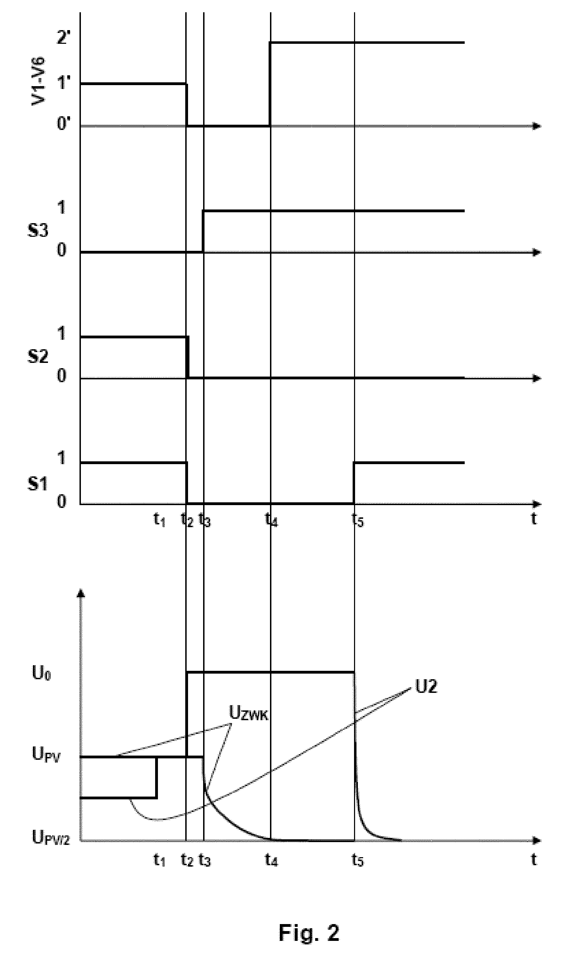

**Fig. 2** zeigt die Signale, mit denen die Schalter S1 bis S3 und V1 bis V6 infolge des Registrierens einer Überspannung angesteuert werden, um den Photovoltaikgenerator 1 kurzzuschließen, und die daraus resultierenden Spannungen. Zunächst ist für einen Zeitraum bis t1 der Normalbetrieb gezeigt. In diesem werden die Halbleiterschalter V1 bis V6 getaktet, was mit einem Ansteuersignal von 1' angegeben ist. Die Schütze S1 und S2 sind geschlossen. Die entsprechenden Ansteuersignale stehen auf 1. Der Schalter S3 ist offen. Das entsprechende Ansteuersignal steht auf 0. Die Zwischenkreisspannung $U_{ZWK}$ weist denselben Wert wie die Photovoltaikspannung $U_{PV}$ auf. Die Beträge der von den beiden Voltmetern 11 und 12 gemessenen Spannungen U1 und U2 gegenüber Erde betragen jeweils $U_{PV/2}$. Dargestellt ist hier der Verlauf des Betrages der von dem Voltmeter 12 gemessenen Spannung U2. Zum Zeitpunkt t1 tritt ein Erdschlussfehler auf, der den Anschluss 9 hart mit Erde verbindet. Entsprechend steigt das Potential des Anschlusses 10, d. h. U2, auf $U_{PV}$ an, was an dem Voltmeter 12 registriert wird. Wenn, wie in dem in der Figur gezeigten Beispiel angenommen, der Betrag der Spannung $U_{PV}$ die zulässige Isolationsbemessungsspannung der Photovoltaikmodule übersteigt, so werden als Reaktion darauf zum Zeitpunkt t2 die Schütze S1 und S2 und alle Halbleiterschalter V1 bis V6 geöffnet. In der Folge steigt die Spannung U2 auf die Leerspannung $U_0$ des Photovoltaikgenerators an. Zum Zeitpunkt t3 wird dann der Schalter S3 geschlossen, um die Zwischenkreiskapazität 4 zu entladen. Entsprechend fällt die Zwischenkreisspannung $U_{ZWK}$ exponentiell ab. Zum Zeitpunkt t4 ist die Zwischenkreisspannung auf eine Schwellspannung abgefallen, bei der die Halbleiterschalter V1 bis V6 gefahrlos permanent geschlossen werden können, was durch ein Ansteuersignal vom Wert 2' angedeutet ist. Wenn zum folgenden Zeitpunkt t5 das Schütz S1 wieder geschlossen wird und den Photovoltaikgenerator erneut mit dem Wechselrichter verbindet, wird dieser durch die geschlossenen Halbleiterschalter V1 bis V6 der Wechselrichterbrücke 5 kurzgeschlossen, sodass die Spannung U2 schnell gegen null abfällt. Der Zeitraum zwischen t1 und dem Abfall von U2 unter den Anfangswert von $U_{PV/2}$ und damit unter die Isolationsbemessungsspannung der Photovoltaikmodule des Photovoltaikgenerators beträgt wenige Sekunden und kann auf drei, zwei oder sogar eine Sekunde begrenzt werden. Die in Fig. 2 gezeigten Abstände der Zeitpunkte t1 bis t5 sind nicht unbedingt maßstäblich, so kann zum Beispiel das Intervall von t4 bis t5 deutlich kürzer ausfallen als dargestellt, zudem müssen nicht alle zu einem Zeitpunkt zusammenfallend dargestellten Schaltereignisse gleichzeitig erfolgen. Auf die verschiedenen Variationsmöglichkeiten bezüglich der Abfolge der Schaltereignisse wurde bereits hingewiesen.

**BEZUGSZEICHENLISTE**

| | |
|---|---|
| 1 | Photovoltaikgenerator |
| 2 | Zwischenkreis |
| 3 | Wechselrichter |
| 4 | Zwischenkreiskapazität |
| 5 | Wechselrichterbrücke |
| 6 | Wechselstromnetz |
| 7 | Transformator |
| 8 | Halbbrücke |
| 9 | Anschluss |
| 10 | Anschluss |
| 11 | Voltmeter |
| 12 | Voltmeter |
| S1 | Schütz |

S2      Schütz
S3      Schalter
V1      Halbleiterschalter
V2      Halbleiterschalter
V3      Halbleiterschalter
V4      Halbleiterschalter
V5      Halbleiterschalter
V6      Halbleiterschalter
R1      Widerstand
R2      Entladungswiderstand
$U_{ZWK}$    Zwischenkreisspannung
$U_{PV}$     Photovoltaikspannung
$U_0$        Leerlaufspannung
U2      Spannung an Anschluss 10 gegenüber Erde
        (gemessen von Voltmeter 12)

**Patentansprüche**

1.  Verfahren, um einen Photovoltaikgenerator (1), der eine Leerlaufspannung aufweist, welche größer als eine Isolationsbemessungsspannung seiner Photovoltaikmodule ist, und der über einen Wechselrichter (3) an ein Wechselstromnetz (6) angeschlossen ist, beim Auftreten eines Erdschlussfehlers vor einer resultierenden, die Isolationsbemessungsspannung überschreitenden Überspannung gegenüber Erde zu schützen, wobei das Verfahren die Schritte aufweist:

    - Überwachen des Photovoltaikgenerators (1) auf das Auftreten des Erdschlussfehlers oder der resultierenden Überspannung und
    - Kurzschließen des Photovoltaikgenerators (1) beim Auftreten des Erdschlussfehlers oder der resultierenden Überspannung,

    **dadurch gekennzeichnet, dass** beim Auftreten des Erdschlussfehlers oder der resultierenden Überspannung

    - zunächst der Photovoltaikgenerator (1) von einer eingangsseitigen Zwischenkreiskapazität (4) des Wechselrichters (3) und der Wechselrichter (3) von dem Wechselstromnetz (6) getrennt wird,
    - dann die eingangsseitige Zwischenkreiskapazität (4) des Wechselrichters (3) über einen Widerstand (R1) entladen wird,
    - bevor Halbleiterschalter (V1 bis V6) einer Wechselrichterbrücke (5) des Wechselrichters (3) permanent geschlossen werden und der Photovoltaikgenerator (1) wieder mit der eingangsseitigen Zwischenkreiskapazität (4) des Wechselrichters (3) verbunden wird, um den Photovoltaikgenerator (1) kurzzuschließen.

2.  Verfahren nach Anspruch 1, **dadurch gekenn-**

**zeichnet, dass** der Photovoltaikgenerator (1) von der eingangsseitigen Zwischenkreiskapazität (4) des Wechselrichters (3) durch Öffnen eines allpolig trennenden ersten Schützes (S1) getrennt wird, dass der Wechselrichter (3) von dem Wechselstromnetz (6) durch Öffnen eines allpolig trennenden zweiten Schützes (S2) getrennt wird und dass die eingangsseitige Zwischenkreiskapazität (4) des Wechselrichters (3) durch Schließen eines mit dem Widerstand (R1) in Reihe geschalteten Schalters (S3) entladen wird.

3.  Verfahren nach Anspruch 2, **dadurch gekennzeichnet, dass** der Schalter (S3) ein Relais, ein Schütz oder ein weiterer Halbleiterschalter ist.

4.  Verfahren nach einem der vorhergehenden Ansprüche, **dadurch gekennzeichnet, dass** alle Halbleiterschalter (V1 bis V6) der Wechselrichterbrücke (5) des Wechselrichters (3) permanent geschlossen werden, um den Photovoltaikgenerator (1) kurzzuschließen.

5.  Verfahren nach Anspruch 4, **dadurch gekennzeichnet, dass** alle Halbleiterschalter (V1 bis V6) der Wechselrichterbrücke (5) des Wechselrichters (3) vorübergehend geöffnet werden, bevor der Wechselrichter (3) von dem Wechselstromnetz (6) getrennt wird und bis sie nach dem Entladen der Zwischenkreiskapazität (4) permanent geschlossen werden.

6.  Verfahren nach einem der vorhergehenden Ansprüche, **dadurch gekennzeichnet, dass** der Photovoltaikgenerator (1) zur gleichen Zeit von der eingangsseitigen Zwischenkreiskapazität (4) des Wechselrichters (3) getrennt wird, wie der Wechselrichter (3) von dem Wechselstromnetz (6) getrennt wird.

7.  Verfahren nach einem der vorhergehenden Ansprüche, **dadurch gekennzeichnet, dass** die Halbleiterschalter (V1 bis V6) der Wechselrichterbrücke (5) des Wechselrichters (3) permanent geschlossen werden, bevor der Photovoltaikgenerator (1) wieder mit der eingangsseitigen Zwischenkreiskapazität (4) des Wechselrichters (3) verbunden wird.

8.  Verfahren nach einem der vorhergehenden Ansprüche, **dadurch gekennzeichnet, dass** die permanent geschlossenen Halbleiterschalter (V1 bis V6) der Wechselrichterbrücke (5) des Wechselrichters (3) bei Ausfall des Wechselstromnetzes (6) unter Verwendung von elektrischer Energie aus einem dem Wechselrichter (3) zugeordneten Energiespeicher weiter angesteuert und/oder gekühlt werden.

9.  Verfahren nach einem der vorhergehenden Ansprüche, **dadurch gekennzeichnet, dass** eine Offsetsteuerung für das Potential eines der Anschlüsse (9, 10) des Photovoltaikgenerators (1) am Eingang des Wechselrichters (3) beim Auftreten des Erdschlussfehlers oder der resultierenden Überspannung abgeschaltet wird.

10. Verfahren nach einem der vorhergehenden Ansprüche, **dadurch gekennzeichnet, dass** beim Auftreten eines Erdschlussfehlers, der in keine die Isolationsbemessungsspannung überschreitende Überspannung resultiert, weiter elektrische Energie von dem Photovoltaikgenerator (1) mit dem Wechselrichter (3) in das Wechselstromnetz (6) eingespeist wird.

11. Verfahren nach einem der vorhergehenden Ansprüche, **dadurch gekennzeichnet, dass** der Photovoltaikgenerator (1) durch Messen der Spannung seiner Anschlüsse (9, 10) an den Wechselrichter (3) gegenüber Erde auf das Auftreten des Erdschlussfehlers oder der resultierenden Überspannung überwacht wird.

**Claims**

1. A method of protecting a photovoltaic generator (1) in case of a ground fault against a resulting surge voltage relative to ground, the photovoltaic generator (1) having an open-circuit voltage higher than an insulation design voltage of its photovoltaic modules and being connected to an AC power grid (6) via an inverter (3), the surge voltage exceeding the insulation design voltage, the method comprising the steps:

    - surveying the photovoltaic generator (1) for the occurrence of the ground fault or the resulting surge voltage, and
    - short-circuiting the photovoltaic generator (1) upon occurrence of the ground fault or the resulting surge voltage,

    **characterized in that** upon occurrence of the ground fault or the resulting surge voltage

    - at first, the photovoltaic generator (1) is separated from an input-side intermediate link capacitance (4) of the inverter (3), and the inverter (3) is separated from the AC power grid (6),
    - then, the input-side intermediate link capacitance (4) of the inverter (3) is discharged via a resistor (R1),
    - prior to permanently closing semiconductor switches (V1 to V6) of an inverter bridge (5) of the inverter (3) and to reconnecting the photovoltaic generator (1) to the input-side intermediate link capacitance (4) of the inverter (3) to short circuit the photovoltaic generator (1).

2. The method of claim 1, **characterized in that** the photovoltaic generator (1) is separated from the input-side intermediate link capacitance (4) of the inverter (3) by opening an all-pole separating first contactor (S1), that the inverter (3) is separated from the AC power grid (6) by opening an all-pole separating second contactor (82), and that the input-side intermediate link capacitance (4) of the inverter (3) is discharged by closing a switch (S3) connected in series with the resistor (R1).

3. The method of claim 2, **characterized in that** the switch (S3) is a relay, a contactor or a further semiconductor switch.

4. The method of any of the preceding claims, **characterized in that** all semiconductor switches (V1 to V6) of the inverter bridge (5) of the inverter (3) are permanently closed to short-circuit the photovoltaic generator (1).

5. The method of claim 4, **characterized in that** all semiconductor switches (V1 to V6) of the inverter bridge (5) of the inverter (3) are temporarily opened prior to separating the inverter (3) from the AC power grid (6) and until they are permanently closed after discharging the intermediate link capacitance (4).

6. The method of any of the preceding claims, **characterized in that** the photovoltaic generator (1) is separated from the input-side intermediate link capacitance (4) of the inverter (3) at a same point in time as the inverter (3) is separated from the AC power grid (6).

7. The method of any of the preceding claims, **characterized in that** the semiconductor switches (V1 to V6) of the inverter bridge (5) of the inverter (3) are permanently closed prior to reconnecting the photovoltaic generator (1) to the input-side intermediate link capacitance (4) of the inverter (3).

8. The method of any of the preceding claims, **characterized in that** the permanently closed semiconductor switches (V1 to V6) of the inverter bridge (5) of the inverter (3), upon breakdown of the AC power grid (6), are further operated and/or cooled using electric energy out of an energy storage assigned to the inverter (3).

9. The method of any of the preceding claims, **characterized in that** an offset control for the potential of one of the connections (9, 10) of the photovoltaic generator (1) at the input of the inverter (3) is switched off upon the occurrence of the ground fault or the resulting surge voltage.

**10.** The method of any of the preceding claims, **characterized in that** upon the occurrence of a ground fault, which does not result in a surge voltage exceeding the insulation design voltage, electric energy from the photovoltaic generator (1) is further fed into the AC power grid (6) by the inverter (3).

**11.** The method of any of the preceding claims, **characterized in that** the photovoltaic generator (1) is surveyed for the occurrence of the ground fault or the resulting surge voltage by measuring the voltages of its connections (9, 10) to the inverter (3) relative to ground.

**Revendications**

**1.** Procédé pour protéger un générateur photovoltaïque (1), lequel présente une tension en circuit ouvert qui est supérieure à une tension assignée d'isolation de ses modules photovoltaïques et lequel est raccordé via un onduleur (3) à un réseau de courant alternatif (6), contre une surtension par rapport à la terre résultante dépassant la tension assignée d'isolation en cas d'apparition d'un défaut de mise à la terre, dans lequel le procédé présente les étapes suivantes :

- la surveillance du générateur photovoltaïque (1) quant à l'apparition du défaut de mise à la terre ou de la surtension résultante, et
- le court-circuitage du générateur photovoltaïque (1) en cas d'apparition du défaut de mise à la terre ou de la surtension résultante,

**caractérisé en ce que**, en cas d'apparition du défaut de mise à la terre ou de la surtension résultante,

- le générateur photovoltaïque (1) est tout d'abord déconnecté d'une capacité de circuit intermédiaire côté entrée (4) de l'onduleur (3), et l'onduleur (3) étant déconnecté du réseau de courant alternatif (6),
- la capacité de circuit intermédiaire côté entrée (4) de l'onduleur (3) étant ensuite déchargée via une résistance (R1),
- avant que des commutateurs à semi-conducteur (V1 à V6) d'un pont d'onduleur (5) de l'onduleur (3) soient fermés de manière permanente et que le générateur photovoltaïque (1) soit de reconnecté à la capacité de circuit intermédiaire côté entrée (4) de l'onduleur (3) pour court-circuiter le générateur photovoltaïque (1).

**2.** Procédé selon la revendication 1, **caractérisé en ce que** le générateur photovoltaïque (1) est déconnecté de la capacité de circuit intermédiaire côté entrée (4) de l'onduleur (3) en ouvrant un premier contacteur-interrupteur (S1) déconnectant sur tous les pôles, **en ce que** l'onduleur (3) est déconnecté du réseau de courant alternatif (6) en ouvrant un deuxième contacteur-interrupteur déconnectant sur tous les pôles (S2) et **en ce que** la capacité de circuit intermédiaire côté entrée (4) de l'onduleur (3) est déchargée en fermant un commutateur (S3) couplé en série avec la résistance (R1).

**3.** Procédé selon la revendication 2, **caractérisé en ce que** le commutateur (S3) est un relais, un contacteur-interrupteur ou un autre commutateur à semi-conducteur.

**4.** Procédé selon l'une des revendications précédentes, **caractérisé en ce que** tous les commutateurs à semi-conducteur (V1 à V6) du pont d'onduleur (5) de l'onduleur (3) sont fermés de manière permanente pour court-circuiter le générateur photovoltaïque (1).

**5.** Procédé selon la revendication 4, **caractérisé en ce que** tous les commutateurs à semi-conducteur (V1 à V6) du pont d'onduleur (5) de l'onduleur (3) sont ouverts de manière provisoire avant que l'onduleur (3) soit déconnecté du réseau de courant alternatif (6) et jusqu'à ce qu'ils soient fermés de manière permanente après la décharge de la capacité de circuit intermédiaire (4).

**6.** Procédé selon l'une des revendications précédentes, **caractérisé en ce que** le générateur photovoltaïque (1) est déconnecté de la capacité de circuit intermédiaire côté entrée (4) de l'onduleur (3) au même moment où l'onduleur (3) est déconnecté du réseau de courant alternatif (6).

**7.** Procédé selon l'une des revendications précédentes, **caractérisé en ce que** les commutateurs à semi-conducteur (V1 à V6) du pont d'onduleur (5) de l'onduleur (3) sont fermés de manière permanente avant que le générateur photovoltaïque (1) soit de nouveau relié à la capacité de circuit intermédiaire côté entrée (4) de l'onduleur (3).

**8.** Procédé selon l'une des revendications précédentes, **caractérisé en ce que** les commutateurs à semi-conducteur (V1 à V6) fermés de manière permanente du pont d'onduleur (5) de l'onduleur (3) continuent d'être commandés et/ou refroidis en cas de défaillance du réseau de courant alternatif (6) en utilisant de l'énergie électrique provenant d'un accumulateur d'énergie associé à l'onduleur (3).

**9.** Procédé selon l'une des revendications précédentes, **caractérisé en ce qu'**une commande d'offset pour le potentiel de l'une des connexions (9, 10) du générateur photovoltaïque (1) à l'entrée de l'onduleur (3) est désactivée en cas d'apparition du défaut de mise à la terre ou de la surtension résultante.

10. Procédé selon l'une des revendications précédentes, **caractérisé en ce que**, en cas d'apparition d'un défaut de mise à la terre qui ne résulte pas en une surtension dépassant la tension assignée d'isolation, de l'énergie électrique du générateur photovoltaïque (1) continue d'alimenter avec l'onduleur (3) le réseau de courant alternatif (6).

11. Procédé selon l'une des revendications précédentes, **caractérisé en ce que** le générateur photovoltaïque (1) est surveillé en mesurant la tension de ses connexions (9, 10) à l'onduleur (3) par rapport à la terre quant à l'apparition du défaut de mise à la terre ou de la surtension résultante.

Fig. 1

EP 2 817 828 B1

Fig. 2

12

**IN DER BESCHREIBUNG AUFGEFÜHRTE DOKUMENTE**

**In der Beschreibung aufgeführte Patentdokumente**

- DE 202006008936 U1
- DE 102010017746 A1
- WO 2011135239 A1
- DE 3041078 A1
- DE 102010009120 B4
- EP 2284973 A1